# EUROPEAN PATENT APPLICATION

(11) **EP 4 039 847 A1**
(43) Date of publication of application: **10.08.2022**
(21) Application number: 20873107.5
(22) Date of filing: 24.09.2020
(51) Int. Cl.: C23C 16/18, C23C 16/40, C23C 16/455, H01L 21/31, H01L 21/316

(54) **METHOD FOR PRODUCING YTTRIUM OXIDE-CONTAINING FILM**

(30) Priority: 04.10.2019 JP 2019183551
(71) Applicant: ADEKA CORPORATION, Arakawa-ku Tokyo 116-8554 (JP)
(72) Inventor: NISHIDA, Akihiro, Tokyo 116-8554 (JP); YAMASHITA, Atsushi, Tokyo 116-8554 (JP)
(74) Representative: Müller-Boré & Partner Patentanwälte PartG mbB
(86) International application number: PCT/JP2020/035926
(87) International publication number: WO 2021/065646

(57) **Abstract**

The present invention provides a method for producing an yttrium oxide-containing film by an atomic layer deposition method, including:
a step (A) of introducing a raw material gas obtained by vaporizing a thin film-forming raw material containing tris(sec-butylcyclopentadienyl)yttrium into a processing atmosphere to deposit the tris(sec-butylcyclopentadienyl)yttrium on a substrate; and
a step (B) of reacting the tris(sec-butylcyclopentadienyl)yttrium deposited on the substrate with a reactive gas containing a gas selected from the group consisting of oxygen plasma, ozone, ozone plasma, and mixtures thereof in the processing atmosphere to oxidize yttrium.

## Description

### Technical Field

This invention relates to a method for producing an yttrium oxide-containing film by an atomic layer deposition method.

### Background Art

It is known that yttrium oxide films exhibit high heat resistance, plasma resistance, and light transmissivity and can be used as, for example, heat-resistant protective films, plasma-resistant protective films, and optical thin films.

Methods for producing these thin films can be exemplified by sputtering methods, ion plating methods, MOD methods such as coating pyrolysis methods and sol-gel methods, CVD methods, and atomic layer deposition methods (hereinafter referred to as "ALD methods"), which are a type of CVD methods. ALD methods are mainly used among these methods since the ALD methods have numerous advantages such as excelling in composition controllability and stepwise coating ability, being suitable for mass production, and enabling hybrid accumulation.

Patent Document 1 discloses a method for producing an yttrium oxide film by an ALD method that uses tris(sec-butylcyclopentadienyl)yttrium as the thin film-forming raw material and water vapor as the reactive gas.

Patent Document 2 discloses a method for producing an yttrium oxide film by a CVD method that uses tris(sec-butylcyclopentadienyl)yttrium as the thin film-forming raw material and oxygen gas as the reactive gas.

Non-Patent Document 1 discloses a method for producing an yttrium oxide film by an ALD method that uses tris(isopropylcyclopentadienyl)yttrium as the thin film-forming raw material and ozone as the reactive gas.

### Citation List

### Patent Document

[Patent Document 1] Japanese Patent Application Publication No. 2018-168398
[Patent Document 2] Japanese Patent Application Publication No. 2008-274374

### Non-Patent Document

[Non-Patent Document 1] ECS Transactions, 50(13) 107-116 (2012), @The Electrochemical Society, "Growth Characterstics and Properties of Yttrium Oxide Thin Films by Atomic Layer Deposition from Novel Y(iPrCp)3 Precursor and O3"

### Summary of Invention

### Technical Problem

In the production of yttrium oxide films by ALD methods, the reaction of the reactive gas and the yttrium compound deposited on the substrate has to be followed by the exhaust of unreacted reactive gas and by-product gas. However, with the method described in Patent Document 1, which uses water vapor as the reactive gas, the time required to exhaust the water vapor has been a problem. In addition, when improved productivity has been sought by shortening the film-formation cycle time with a condition under which water vapor exhaust is not thorough, the problem has arisen that carbon compounds originating with the by-product gas remain behind in the resulting yttrium oxide film, whereby a high-quality film is not obtained.

In addition, the reaction between the thin film-forming raw material and the reactive gas has to be carried out at high temperatures when oxygen gas is used as the reactive gas. According to the description in Patent Document 2, an yttrium oxide film was produced by the CVD method using tris(sec-butylcyclopentadienyl)yttrium as the thin film-forming raw material and oxygen gas as the reactive gas, and by carrying out the reaction with tris(sec-butylcyclopentadienyl)yttrium at 600°C using 400°C oxygen gas. However, the problem of significant damage to the substrate arose due to the high-temperature reaction. Moreover, when the reaction between the raw material and oxygen gas was run at a lower temperature, the reactivity of the oxygen gas was reduced and the problem of carbon remaining in the yttrium oxide film ended up occurring.

With regard to the use, as described in Non-Patent Document 1, of tris(isopropylcyclopentadienyl)yttrium as the thin film-forming raw material for the ALD method, this is a solid compound at normal temperature and, as a consequence, heating was required prior to introduction into the ALD apparatus to bring about conversion into a liquid. In addition, it was also necessary to heat all of the pipework of the ALD apparatus in order to prevent solidification of the tris(isopropylcyclopentadienyl)yttrium, and a complex production control was thus required.

Accordingly, the object of this invention is to provide a method for producing an yttrium oxide-containing film by an ALD method, in which the production method uses a thin film-forming raw material that does not require complex production control and the production method enables the production of a high-quality yttrium oxide film even using a shortened film-formation cycle time.

### Solution to Problem

As a result of extensive and intensive investigations, the inventors discovered a method for producing an yttrium oxide-containing film by an ALD method, in which this production method uses a thin film-forming raw material that does require a complex production control and this production method can provide both a substantial shortening of the film-formation cycle time and the production of a high-quality yttrium oxide film. The inventors achieved this invention based on this discovery.

That is, this invention relates to a method for producing an yttrium oxide-containing film on a substrate by an ALD method, and provides an yttrium oxide-containing film production method comprising: a step (A) (hereinafter referred to as the "step (A)") of introducing a raw material gas obtained by vaporizing a thin film-forming raw material containing tris(sec-butylcyclopentadienyl)yttrium into a processing atmosphere to deposit the tris(sec-butylcyclopentadienyl)yttrium on a substrate; and a step (B) (hereinafter referred to as the "step (B)") of reacting the tris(sec-butylcyclopentadienyl)yttrium deposited on the substrate with a reactive gas containing a gas selected from the group consisting of oxygen plasma, ozone, ozone plasma, and mixtures thereof in the processing atmosphere to oxidize yttrium.

The temperature of the substrate in the step (B) in the production method of this invention is preferably in a range from 150°C to 400°C.

In addition, in the step (B), the pressure of the processing atmosphere when the tris(sec-butylcyclopentadienyl)yttrium deposited on the substrate reacts with the reactive gas is preferably in a range from 0.1 Pa to 10,000 Pa in the production method of this invention.

The production method of this invention also preferably includes a step of exhausting the gas of the processing atmosphere between the step (A) and the step (B) and/or after the step (B).

Preferably a film-formation cycle comprising the step (A) and the step (B) is repeated in this sequence in the production method of this invention.

### Advantageous Effects of Invention

Due to the use of a thin film-forming raw material that contains tris(sec-butylcyclopentadienyl)yttrium, which is a liquid at normal temperature, this invention is free of the requirement for heating of the raw material prior to introduction into the ALD apparatus and the requirement for heating of the pipework in the apparatus. In addition, due to the use of a reactive gas containing a gas selected from the group consisting of oxygen plasma, ozone, ozone plasma, and mixtures thereof, this invention can shorten the time of the exhaust step carried out after the step (B), in comparison to the use of water vapor in the reactive gas. Thus, a high-quality yttrium oxide-containing film containing little residual carbon can be produced at good productivities, without carrying out a complex production control and with a substantial shortening of the film-formation cycle time.

### Brief Description of Drawings

Fig. 1 is a schematic diagram that shows an example of an ALD apparatus used in the method of this invention for producing an yttrium oxide-containing film.
Fig. 2 is a schematic diagram that shows another example of an ALD apparatus used in the method of this invention for producing an yttrium oxide-containing film.
Fig. 3 is a schematic diagram that shows yet another example of an ALD apparatus used in the method of this invention for producing an yttrium oxide-containing film.
Fig. 4 is a schematic diagram that shows still another example of an ALD apparatus used in the method of this invention for producing an yttrium oxide-containing film.

### Description of Embodiments

The production method of this invention can use the same procedures as well-known common ALD methods, but the production of an yttrium oxide-containing film using a combination of the step (A) and the step (B) described in the following is a characteristic feature of this invention.

The step (A) in the production method of this invention is a step of depositing tris(sec-butylcyclopentadienyl)yttrium on a substrate by introducing, into a processing atmosphere, a raw material gas provided by vaporizing a thin film-forming raw material that contains tris(sec-butylcyclopentadienyl)yttrium. Here, "depositing" indicates a concept that includes the adsorption of tris(sec-butylcyclopentadienyl) yttrium to a substrate. Tris(sec-butylcyclopentadienyl)yttrium is a compound that is a liquid at normal temperature and thus is a compound that exhibits excellent handling characteristics. As a consequence, the use of a thin film-forming raw material that contains tris(sec-butylcyclopentadienyl)yttrium eliminates the requirement for heating the raw material prior to its introduction into the ALD apparatus and the requirement for heating the pipework within the apparatus, and this, in turn, enables the formation of an yttrium oxide-containing film without requiring a complex production control.

With reference to the introduction, into the film-formation chamber (processing atmosphere) of the ALD apparatus, of the raw material gas provided by the vaporization of a thin film-forming raw material that contains tris(sec-butylcyclopentadienyl)yttrium, the raw material gas preferably contains at least 90 volume% of tris(sec-butylcyclopentadienyl)yttrium and more preferably contains at least 99 volume%.

There is no particular limitation here on the method for producing the tris(sec-butylcyclopentadienyl)yttrium used in this invention, and production can be carried out using well-known reactions. For example, synthesis can be carried out by a salt exchange reaction between an yttrium halide, such as the trichloride and tribromide, and an alkali metal complex, such as sec-butylcyclopentadienylsodium, and sec-butylcyclopentadienylpotassium.

In the method of this invention for producing an yttrium oxide-containing film by an ALD method, the thin film-forming raw material should contain tris(sec-butylcyclopentadienyl)yttrium and should function as a thin film precursor, and its composition will vary depending on the type of thin film being sought. For example, in the case of the production of a thin film that contains only yttrium for the metal, the thin film-forming raw material of this invention will not contain a non-yttrium metal compound or a semimetal compound. In the case, on the other hand, of the production of a thin film that contains yttrium and a non-yttrium metal and/or a semimetal, the thin film-forming raw material of this invention can contain, in addition to tris(sec-butylcyclopentadienyl)yttrium, a compound containing the desired metal and/or a compound containing the desired semimetal (hereinafter referred to as "other precursor").

There are no particular limitations on the other precursor that can be used with the tris(sec-butylcyclopentadienyl)yttrium in a multicomponent system ALD method that uses a plurality of precursors, and well-known common precursors used as thin film-forming raw materials in ALD methods can be used.

This other precursor can be exemplified by compounds between silicon or a metal and one, or two or more selected from the group consisting of compounds used as organic ligands, such as alcohol compounds, glycol compounds, β-diketone compounds, cyclopentadiene compounds, organic amine compounds. The metal species in the precursor can be exemplified by lithium, sodium, potassium, magnesium, calcium, strontium, barium, titanium, zirconium, hafnium, vanadium, niobium, tantalum, chromium, molybdenum, tungsten, manganese, iron, osmium, ruthenium, cobalt, rhodium, iridium, nickel, palladium, platinum, copper, silver, gold, zinc, aluminum, gallium, indium, germanium, lead, antimony, bismuth, radium, scandium, ruthenium, yttrium, lanthanum, cerium, praseodymium, neodymium, promethium, samarium, europium, gadolinium, terbium, dysprosium, holmium, erbium, thulium, ytterbium, and lutetium.

The alcohol compound used as an organic ligand in the other precursor can be exemplified by alkyl alcohols such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylaminoalcohols such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

The glycol compounds used as an organic ligand in the other precursor can be exemplified by 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

The β-diketone compounds used as an organic ligand in the other precursor can be exemplified by alkyl-substituted β-diketones such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

The cyclopentadiene compounds used as an organic ligand in the other precursor can be exemplified by cyclopentadiene, methylcyclopentadiene, ethylcyclopentadiene, propylcyclopentadiene, isopropylcyclopentadiene, butylcyclopentadiene, sec-butylcyclopentadiene, isobutylcyclopentadiene, tert-butylcyclopentadiene, dimethylcyclopentadiene, tetramethylcyclopentadiene, and pentamethylcyclopentadiene. The organic amine compounds used as this organic ligand can be exemplified by methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

These other precursors are known in the related technical field and methods for producing the same are also known. In an example of the method for producing the case of use of an alcohol compound as the organic ligand, the precursor can be produced by reacting an alkali metal alkoxide of the alcohol compound with an inorganic salt of a metal as described above or with the hydrate of this inorganic salt. This inorganic salt of the metal or hydrate thereof can be exemplified by metal halides and metal nitrates, while the alkali metal alkoxide can be exemplified by sodium alkoxides, lithium alkoxides, and potassium alkoxides.

The multicomponent system ALD method described above includes methods in which each component in the thin film-forming raw material is vaporized and supplied independently (hereinafter also referred to as "single source methods"), and methods in which a raw material mixture, provided by preliminarily mixing the multiple raw material components in the desired composition, is vaporized and supplied (hereinafter also referred to as "cocktail source methods").

In the case of single source methods, the other precursor is preferably a compound that has a thermal and/or oxidative decomposition behavior similar to that of tris(sec-butylcyclopentadienyl)yttrium.

In the case of cocktail source methods, the other precursor is preferably a compound that, in addition to having a thermal and/or oxidative decomposition behavior similar to that of tris(sec-butylcyclopentadienyl)yttrium, does not cause changes during mixing, for example, due to a chemical reaction.

Also in the case of cocktail source methods, the thin film-forming raw material can be a mixture of tris(sec-butylcyclopentadienyl)yttrium and the other precursor or can be a mixed solution provided by dissolving such a mixture in an organic solvent.

There are no particular limitations on this organic solvent, and a well-known common organic solvent can be used. The organic solvent can be exemplified by acetate esters such as ethyl acetate, butyl acetate, and methoxyethyl acetate; ethers such as tetrahydrofuran, tetrahydropyran, ethylene glycol dimethyl ether, diethylene glycol dimethyl ether, triethylene glycol dimethyl ether, dibutyl ether, and dioxane; ketones such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons such as hexane, cyclohexane, methylcyclohexane, dimethylcyclohexane, ethylcyclohexane, heptane, octane, toluene, and xylene; hydrocarbons having a cyano group such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; pyridine; and lutidine. Depending on, inter alia, the solute solubility and the relationship between the operating temperature and the boiling point or flash point, a single one of these organic solvents may be used by itself or a mixture of two or more may be used.

When, in the production method of this invention, a solution of an organic solvent mixed with tris(sec-butylcyclopentadienyl)yttrium is used as the thin film-forming raw material, the organic solvent is preferably added so as to provide a total amount of precursors in the thin film-forming raw material of 0.01 mol/L to 2.0 mol/L and particularly 0.05 mol/L to 1.0 mol/L.

For the case in which the thin film-forming raw material does not contain a non-yttrium metal compound and does not contain a semimetal compound, this "total amount of precursors" is the total amount of tris(sec-butylcyclopentadienyl)yttrium and yttrium-containing other precursor. For the case in which the thin film-forming raw material contains an other precursor besides the tris(sec-butylcyclopentadienyl)yttrium, this "total amount of precursors" is the total amount of tris(sec-butylcyclopentadienyl)yttrium and other precursors.

The thin film-forming raw material may optionally contain a nucleophilic reagent in order to improve the stability of the tris(sec-butylcyclopentadienyl)yttrium and other precursor. Examples of this nucleophilic reagent are ethylene glycol ethers such as glyme, diglyme, triglyme, and tetraglyme; crown ethers such as 18-crown-6, dicyclohexyl-18-crown-6, 24-crown-8, dicyclohexyl-24-crown-8, and dibenzo-24-crown-8; polyamines such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines such as cyclam and cyclen; heterocyclic compounds such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-ketoesters such as methyl acetoacetate, ethyl acetoacetate, and 2-methoxyethyl acetoacetate; and β-diketones such as acetylacetone, 2,4-hexanedione, 2,4-heptanedione, 3,5-heptanedione, and dipivaloylmethane. The use amount of these nucleophilic reagents, per 1 mole of the total amount of precursors, is preferably in the range from 0.1 mol to 10 mol and is more preferably in the range from 1 mol to 4 mol.

Other than the components constituting the same, the thin film-forming raw material used in the production method of this invention desirably does not contain, to the greatest extent possible, a metal element impurity content, halogen impurity content, such as chlorine impurities, and an organic impurity content. With regard to the metal element impurity content, each element is preferably not more than 100 ppb and more preferably not more than 10 ppb and the total amount is preferably not more than 1 ppm and more preferably not more than 100 ppb. Particularly in the case of use as a gate insulating film, gate film, or barrier layer in LSI, the content of alkali metal elements and alkaline-earth metal elements, which influence the electrical characteristics of the resulting thin film, must be small. The halogen impurity content is preferably not more than 100 ppm, more preferably not more than 10 ppm, and still more preferably not more than 1 ppm. The organic impurity content, considered in terms of the total amount, is preferably not more than 500 ppm, more preferably not more than 50 ppm, and still more preferably not more than 10 ppm. In addition, because the moisture content is a cause of the generation of particles in the thin film-forming raw material and the generation of particles during thin film formation, the moisture content should be preliminarily removed to the greatest extent possible at the time of use from the precursor, organic solvent, and nucleophilic reagent in order to reduce the moisture content in each. The water content in each of the precursor, organic solvent, and nucleophilic reagent is preferably not more than 10 ppm and more preferably not more than 1 ppm.

In order to reduce or prevent particle contamination of the resulting thin film, the thin film-forming raw material in the production method of this invention preferably does not contain particles to the greatest possible extent. Specifically, in the measurement of the particles in the liquid phase using a light-scattering-type liquid-borne particle sensor, preferably the number of particles larger than 0.3 µm is not more than 100 in 1 mL of the liquid phase and more preferably the number of particles larger than 0.2 µm is not more than 100 in 1 mL of the liquid phase.

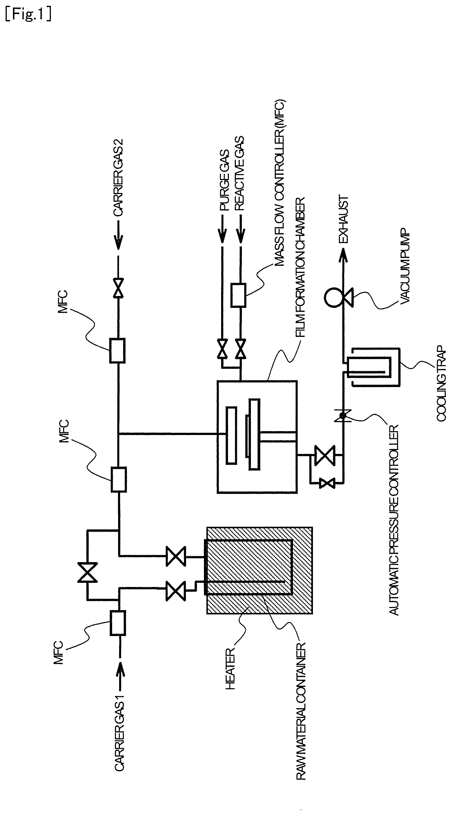

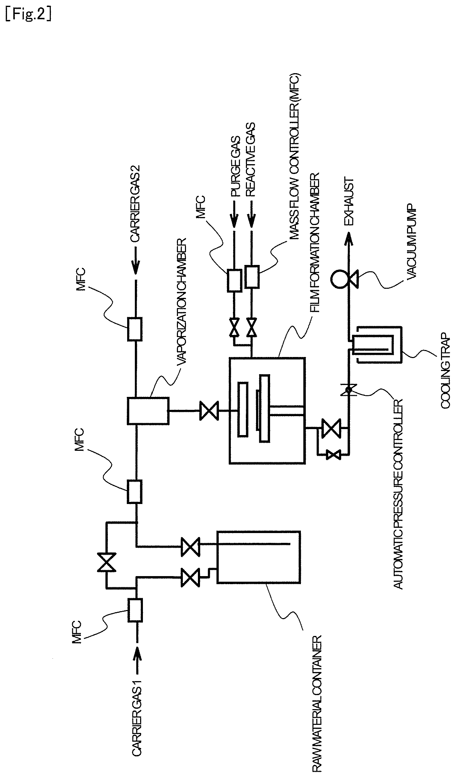

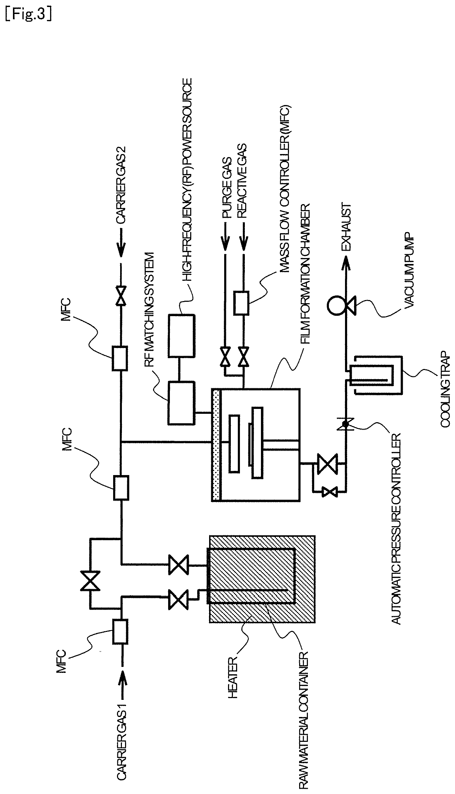

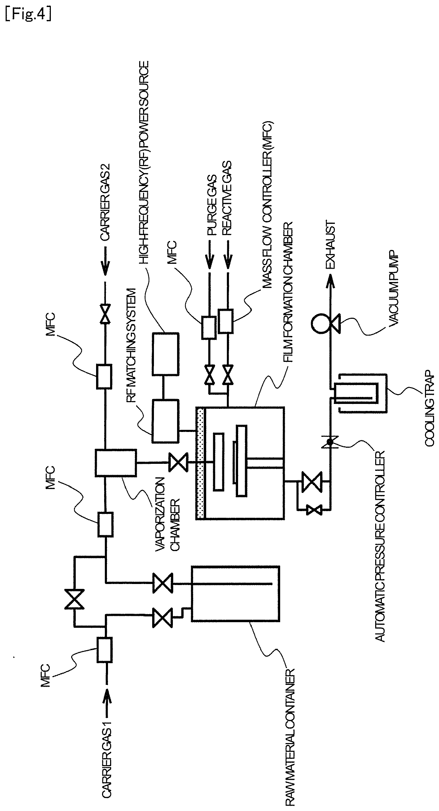

Well-known ALD apparatuses can be used for the apparatus used in the method of this invention for producing yttrium oxide-containing films using the thin film-forming raw material as described in the preceding. The following are examples of specific apparatuses: apparatuses that can carry out a bubbling feed of the precursor, as shown in Fig. 1 and Fig. 3, and apparatuses that have a vaporization compartment, as shown in Fig. 2 and Fig. 4. Other examples are apparatuses that can carry out plasma treatment on the reactive gas, as shown in Fig. 3 and Fig. 4. There is no limitation to single-wafer apparatuses provided with a film formation chamber, as shown in Fig. 1 to Fig. 4, and use can also be made of a apparatus that uses a batch oven and is capable of simultaneously processing a plurality of wafers.

The following methods are available for introducing, into the processing atmosphere, the raw material gas provided in the production method of this invention by vaporizing the thin film-forming raw material in the step (A): gas transport methods, in which a vapor is produced by volatilization by the application of heat and/or reduced pressure to a container (hereinafter referred to as the "raw material container") in which the thin film-forming raw material for ALD is stored, and this is introduced, optionally along with a carrier gas such as argon, nitrogen, or helium, into a film formation chamber (the processing atmosphere) where the substrate is disposed; and liquid transport methods, in which the thin film-forming raw material in liquid or solution form is transported to a vaporization compartment, a vapor is produced by volatilization by the application of heat and/or reduced pressure at the vaporization compartment, and this vapor is introduced into the film formation chamber.

In the case of gas transport methods, tris(sec-butylcyclopentadienyl)yttrium can itself be used as the thin film-forming raw material.

In the case of liquid transport methods, tris(sec-butylcyclopentadienyl)yttrium as such can be used as the thin film-forming raw material since it is a liquid at normal temperature; however, a solution provided by mixing tris(sec-butylcyclopentadienyl)yttrium with an organic solvent may also be used as the thin film-forming raw material.

There are no particular limitations on the method for volatilizing the tris(sec-butylcyclopentadienyl)yttrium-containing thin film-forming raw material in the step (A) in the production method of this invention, and this can be carried out using the organometal compound volatilization methods used in well-known common ALD methods. For example, volatilization can be carried out by the application of heat and/or reduced pressure in the raw material container in the ALD apparatus shown in Fig. 1.

The following, for example, can be used for the material of the substrate placed in the film formation chamber: silicon; ceramics such as indium arsenide, indium gallium arsenide, silicon oxide, silicon nitride, boron nitride, silicon carbide, aluminum oxide, aluminum nitride, tantalum oxide, tantalum nitride, titanium oxide, titanium nitride, titanium carbide, ruthenium oxide, zirconium oxide, hafnium oxide, lanthanum oxide, and gallium nitride; glass; and platinum, ruthenium, aluminum, copper, nickel, cobalt, tungsten, molybdenum, and stainless steel, and their alloys. In addition, the surface of the substrate may be coated.

The shape of the substrate may be, for example, a plate shape, a spherical shape, a fibrous form, a scaly shape, or particulate (particularly fine particles). The surface of the substrate may be flat or may present a three-dimensional structure, such as a trench structure.

The step (B) in the production method of this invention is a step of oxidizing the yttrium by reacting, in the processing atmosphere, the tris(sec-butylcyclopentadienyl)yttrium deposited on the substrate with a reactive gas containing a gas selected from the group consisting of oxygen plasma, ozone, ozone plasma, and mixtures thereof.

The reactive gas in this step contains a gas selected from the group consisting of oxygen plasma, ozone, ozone plasma, and mixtures thereof. The use of these gases in the reactive gas facilitates exhaust from the processing atmosphere in comparison to the case in which water vapor is contained, and this can shorten the time required for the exhaust step.

In addition, the reactive gas may be generated outside the film formation chamber and introduced into the film formation chamber, and oxygen gas or ozone gas may be converted into a plasma in the film formation chamber using the ALD apparatus as shown in Fig. 3 and Fig. 4. The method for generating the oxygen plasma, ozone, and ozone plasma and the method for introduction into the film formation chamber is not particularly limited and the methods used in well-known common ALD methods can be used.

The reactive gas may be a single gas or may be a mixed gas with a gas such as argon, nitrogen, oxygen, hydrogen, and so forth. In the case of a mixed gas, the concentration, with reference to the mixed gas, of the gas selected from the group consisting of oxygen plasma, ozone, ozone plasma, and their mixtures is preferably in the range from 0.01 volume% to 50 volume%, more preferably 0.1 volume% to 20 volume%, and still more preferably 1.0 volume% to 15 volume%.

The amount of moisture in the mixed gas in the step (B) is preferably not more than 0.1 mass% and is more preferably not more than 0.01 mass%.

The yttrium oxide-containing film yielded by the production method of this invention may be a thin film that contains at least 5 mass% of yttrium oxide, and can be exemplified by yttrium oxide, yttria-stabilized zirconian yttrium orthovanadate, yttrium oxide sulfide, yttrium · barium · copper oxide, and yttrium aluminate. Among these, the production method of this invention is well suited as a method for producing yttrium oxide films.

A method for producing an yttrium oxide-containing film on a silicon substrate using the production method of this invention will be described as an example. The ALD apparatus shown in Fig. 1 is used here.

A silicon substrate is first placed in the film formation chamber. There are no particular limitations on the method for inserting this silicon substrate, and the substrate may be placed in the film formation chamber using a well-known common method. Tris(sec-butylcyclopentadienyl)yttrium is volatilized in the raw material container. The temperature of the raw material container in this case is preferably in the range from 20°C to 200°C. The raw material gas containing the volatilized tris(sec-butylcyclopentadienyl)yttrium is then introduced into the film formation chamber and is deposited (adsorbed) onto the silicon substrate that has been heated preferably to 20°C to 400°C and more preferably to 150°C to 250°C (step (A)).

The pressure in the film formation chamber when the tris(sec-butylcyclopentadienyl)yttrium is introduced into the film formation chamber in the step (A) is in the range from 0.1 Pa to 10,000 Pa, preferably 1 Pa to 1,000 Pa, and more preferably 10 Pa to 500 Pa.

The tris(sec-butylcyclopentadienyl)yttrium that has not undergone deposition onto the silicon substrate is then exhausted from the film formation chamber (exhaust step 1). While the tris(sec-butylcyclopentadienyl)yttrium that has not undergone deposition onto the silicon substrate ideally is completely exhausted from the film formation chamber, a complete exhaust is not necessarily required. The exhaust method can be exemplified by the following: methods in which the interior of the system is purged by an inert gas such as helium or argon; methods in which exhaust is carried out by reducing the pressure within the system; and methods that combine the preceding. The vacuum in the case of pressure reduction is preferably 0.01 Pa to 300 Pa and more preferably 0.1 Pa to 150 Pa.

Yttrium oxidation (step (B)) is then performed by carrying out a reaction in the film formation chamber between the tris(sec-butylcyclopentadienyl)yttrium deposited on the silicon substrate and a reactive gas that contains a gas selected from the group consisting of oxygen plasma, ozone, ozone plasma, and their mixtures. The temperature of the substrate when heat is applied in this step is preferably in the range of 150°C, where tris(sec-butylcyclopentadienyl)yttrium vapor is obtained, to 400°C and is more preferably in the range of 150°C to 300°C and still more preferably in the range of 150°C to 250°C. The difference between the substrate temperature in the step (A) and the temperature of the substrate when heat is applied in the step (B) is preferably in the range from 0°C to 20°C as the absolute value. This is because the effect of impeding the occurrence of warping of the yttrium oxide-containing film is seen when regulation into this range is performed.

However, an yttrium oxide-containing film originating with tris(sec-butylcyclopentadienyl)yttrium can be formed even when the temperature of the substrate is less than 150°C.

The pressure of the processing atmosphere when the reactive gas is reacted with tris(sec-butylcyclopentadienyl)yttrium in the step (B) is in the range from 0.1 Pa to 10,000 Pa, preferably 1 Pa to 1,000 Pa, and more preferably 10 Pa to 500 Pa. A high-quality thin film that does not contain residual carbon can be obtained by adjusting to this range.

The unreacted reactive gas and by-product gas are then exhausted from the film formation chamber (exhaust step 2). While the unreacted reactive gas and by-product gas ideally are completely exhausted from the film formation chamber, a complete exhaust is not necessarily required. The exhaust method can be exemplified by the following: methods in which the interior of the system is purged with an inert gas such as helium or argon; methods in which exhaust is carried out by reducing the pressure within the system; and methods that combine the preceding. The vacuum in the case of pressure reduction is preferably 0.01 Pa to 300 Pa and more preferably 0.1 Pa to 150 Pa.

Designating the sequence of operations comprising the step (A), exhaust step 1, the step (B), and exhaust step 2 as described above to be 1 cycle, this cycle may be repeated a plurality of times until an yttrium oxide-containing film of the required film thickness is obtained.

In addition, energy, such as plasma, light, and voltage may also be applied in the production method of this invention. The time period for the application of this energy is not particularly limited and, for example, may be the time when the tris(sec-butylcyclopentadienyl)yttrium is vaporized and introduced into the film formation chamber in the step (A), or may be the time when the system interior is exhausted in an exhaust step, or may be between these individual steps.

Thin film deposition may be followed in the production method of this invention by an annealing treatment in an inert gas atmosphere or a reducing gas atmosphere, in order to obtain a better film quality, while a reflow step may be provided when step embedment is required. The temperature in this case is 400°C to 1,200°C and preferably 500°C to 800°C.

### Examples

The invention is described in greater detail hereinbelow with examples and comparative examples. However, the invention is in no way limited to these examples, etc. that follow.

### [Example 1]

Using tris(sec-butylcyclopentadienyl)yttrium (product name "Y-5000", ADEKA Corporation) as the thin film-forming raw material, an yttrium oxide-containing film was produced on a silicon wafer under the ALD conditions indicated below using the ALD apparatus shown in Fig. 1. When the resulting thin film was subjected to a check of the thin film composition using x-ray photoelectron spectroscopy, the obtained thin film was yttrium oxide and residual carbon was not detected. For the sequence of steps (1) to (4), the time required for 1 cycle was 25.2 seconds.

### (ALD Conditions)

Reaction temperature (silicon wafer temperature): 200°C
Reactive gas: ozone
50 cycles were carried out designating 1 cycle as the sequence of steps comprising the following (1) to (4).
(1) The thin film-forming raw material (hereinafter referred to as the "raw material gas") volatilized at conditions of a raw material container temperature: 180°C and a pressure in the raw material container: 100 Pa, is introduced into the film formation chamber, and deposited for 5 seconds at a system pressure: 100 Pa.
(2) Undeposited raw material gas is removed by a 10-second argon purge.
(3) The reactive gas is introduced into the film formation chamber and a reaction is run for 0.2 seconds at a system pressure: 100 Pa.
(4) Unreacted reactive gas and by-product gas are removed by a 10-second argon purge.

### [Comparative Example 1]

An yttrium oxide-containing film was produced by carrying out the same method as in Example 1, but changing the reactive gas to water vapor. When the resulting thin film was subjected to a check of the thin film composition using x-ray photoelectron spectroscopy, the obtained thin film was yttrium oxide and residual carbon was 1.8 mass%. For the sequence of steps (1) to (4), the time required for 1 cycle was 25.2 seconds.

### [Comparative Example 2]

An yttrium oxide-containing film was produced by carrying out the same method as in Comparative Example 1, but changing the thin film-forming raw material from tris(sec-butylcyclopentadienyl)yttrium to tris(isopropylcyclopentadienyl)yttrium. When the resulting thin film was subjected to a check of the thin film composition using x-ray photoelectron spectroscopy, the obtained thin film was yttrium oxide and residual carbon was 5.6 mass%. For the sequence of steps (1) to (4), the time required for 1 cycle was 25.2 seconds.

### [Comparative Example 3]

An yttrium oxide-containing film was produced by carrying out the same method as in Example 1, but changing the reactive gas to oxygen gas.

When the resulting thin film was subjected to a check of the thin film composition using x-ray photoelectron spectroscopy, the obtained thin film was yttrium oxide and residual carbon was 0.8 mass%. For the sequence of steps (1) to (4), the time required for 1 cycle was 25.2 seconds.

### [Comparative Example 4]

An yttrium oxide-containing film was produced by carrying out the same method as in Comparative Example 1, but changing the argon purge time in the step (4) from 10 seconds to 60 seconds. When the resulting thin film was subjected to a check of the thin film composition using x-ray photoelectron spectroscopy, the obtained thin film was yttrium oxide and residual carbon was not detected. For the sequence of steps (1) to (4), the time required for 1 cycle was 75.2 seconds.

### [Comparative Example 5]

An yttrium oxide-containing film was produced by carrying out the same method as in Comparative Example 4, but changing the argon purge time in the step (2) from 10 seconds to 30 seconds. When the resulting thin film was subjected to a check of the thin film composition using x-ray photoelectron spectroscopy, the obtained thin film was yttrium oxide and residual carbon was not detected. For the sequence of steps (1) to (4), the time required for 1 cycle was 95.2 seconds.

| | Raw material gas | Reactive gas | (2) Argon purge time | (4) Argon purge time | Residual carbon | Cycle time |
|---|---|---|---|---|---|---|
| Example 1 | Compound | Ozone | 10 sec | 10 sec | Not detected | 25.2 sec |
| Comparative Example 1 | Compound | Water vapor | 10 sec | 10 sec | 1.8 mass% | 25.2 sec |
| Comparative Example 2 | Comparative compound | Water vapor | 10 sec | 10 sec | 5.6 mass% | 25.2 sec |
| Comparative Example 3 | Compound | Oxygen | 10 sec | 10 sec | 0.8 mass% | 25.2 sec |
| Comparative Example 4 | Compound | Water vapor | 10 sec | 60 sec | Not detected | 75.2 sec |
| Comparative Example 5 | Compound | Water vapor | 30 sec | 60 sec | Not detected | 95.2 sec |

### Compound: tris(sec-butylcyclopentadienyl)yttrium

### Comparative compound: tris(isopropylcyclopentadienyl)yttrium

According to Comparative Example 1, a purge time of 10 seconds was inadequate when the reactive gas was water vapor, and residual carbon was then detected in the yttrium oxide-containing film and a good quality thin film could not be produced. In addition, according to Comparative Example 2, when tris(isopropylcyclopentadienyl)yttrium was used as the thin film-forming raw material and the reactive gas was water vapor, a purge time of 10 seconds was inadequate, and residual carbon was then detected in the yttrium oxide-containing film and a good quality thin film could not be produced.

Tris(sec-butylcyclopentadienyl)yttrium was used as the thin film-forming raw material in Comparative Examples 4 and 5. Even with the use here of water vapor as the reactive gas, residual carbon was not detected in the resulting thin films when an adequate argon purge time was secured. However, the cycle times were long and satisfactory productivity could not be obtained for the yttrium oxide-containing film.

In contrast to the preceding, when, as shown by Example 1, an yttrium oxide-containing film was produced by an ALD method using tris(sec-butylcyclopentadienyl)yttrium as the thin film-forming raw material and using as the reactive gas a gas selected from the group consisting of oxygen plasma, ozone, ozone plasma, and their mixtures, the productivity was seen to be improved due to the substantially shortened cycle time and a high-quality yttrium oxide-containing film, in which residual carbon was not detected, could be produced.

## Claims

1. A method for producing an yttrium oxide-containing film by an atomic layer deposition method, comprising:
a step (A) of introducing a raw material gas obtained by vaporizing a thin film-forming raw material containing tris(sec-butylcyclopentadienyl)yttrium into a processing atmosphere to deposit the tris(sec-butylcyclopentadienyl)yttrium on a substrate; and
a step (B) of reacting the tris(sec-butylcyclopentadienyl)yttrium deposited on the substrate with a reactive gas containing a gas selected from the group consisting of oxygen plasma, ozone, ozone plasma, and mixtures thereof in the processing atmosphere to oxidize yttrium.

2. The method for producing an yttrium oxide-containing film according to claim 1, wherein the temperature of the substrate in the step (B) is in a range from 150°C to 400°C.

3. The method for producing an yttrium oxide-containing film according to claim 1 or 2, wherein, in the step (B), the pressure of the processing atmosphere when the tris(sec-butylcyclopentadienyl)yttrium deposited on the substrate reacts with the reactive gas is in a range from 0.1 Pa to 10,000 Pa.

4. The method for producing an yttrium oxide-containing film according to any one of claims 1 to 3, comprising a step of exhausting the gas of the processing atmosphere between the step (A) and the step (B) and/or after the step (B).

5. The method for producing an yttrium oxide-containing film according to any one of claims 1 to 4, wherein a film-formation cycle comprising the step (A) and the step (B) is repeated in this sequence.
